Europäisches Patentamt

European Patent Office

Office européen des brevets

(19)

(11) **EP 1 098 449 A1**

(12) **EUROPEAN PATENT APPLICATION**

(43) Date of publication:
**09.05.2001 Bulletin 2001/19**

(51) Int Cl.[7]: **H04B 1/40**, H04B 1/30,
H03H 11/12

(21) Application number: **99121803.3**

(22) Date of filing: **04.11.1999**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI**<br><br>(71) Applicant: **SIEMENS AKTIENGESELLSCHAFT**<br>**80333 München (DE)** | (72) Inventors:<br> • **Thomsen, Pia**<br>  **9440 Aabybro (DK)**<br> • **Christensen, Steen B.**<br>  **9490 Pandrup (DK)** |

(54) **Receiver for receiving signals with different frequency bandwidths in different frequency bands**

(57) The invention relates to a receiver for receiving signals with different frequency bandwidths in different frequency bands. The receiver exhibits a local oscillator (11) to downconvert the received signals to the base band. By using quadrature technique, the in-phase and quadrature signals are available at the baseband output. The base band filters after the quadrature circuit are controllable, so that different receiver bandwidths can be chosen by altering the cut-off frequency. These base band are low pass filters being realised either by using passive elements or by using an active filter implementation, or by using digital filters.

Fig. 1

## Description

Prior art

The invention relates to a receiver for receiving signals with different frequency bandwidths in different frequency bands, in accordance with the generic class of the independent claim.

It is already known to use conventional heterodyne receiver architecture for a multi mode receiver exhibiting a switch for switching between different sets of filters for the intermediate frequency, for example for switching between filters for UMTS (Universal Mobile Telecommunication System) and GSM (Global System for Mobile Communication) input signals. After a downconversion the heterodyne receiver for reception of complex modulation typically exhibits a channel where the received signals are multiplied with an in-phase signal of the local oscillator and a quadrature channel where the received signal is multiplied with the signal of the local oscillator shifted by 90°. After filtering these products by base band filters, the filtered signals are sampled whereafter the digitised signals can be combined, so that the complete signal is recovered.

Advantages of the invention

The receiver for receiving signals with different frequency bandwidths in different frequency bands having the characterising features of the independent claims has the advantage to be realised with less components. Therefore this receiver is smaller and less complex to design and consequently cheaper.

It is an advantage, that for selecting the different modes for reception the filtering at base band is performed by controllable base band filters. In this way, a high degree of flexibility is achieved. Furthermore, due to the use of a controllable filter less components are needed, because not for every frequency band a new complete base band filter is needed.

The features of the dependent patent claims enables further improvements of the invention.

The invention is improved by using digital filters as base band filters. Thus the base band filters are easily reconfigurable, so that by reprogramming the processor on which the digital filter is implemented, the characteristics of the base band filter are changed, for example the cut-off frequency. In addition, digital filters enable nearly every filter characteristic.

It is an advantage to use passive elements for designing the base band filter. Since passive elements are easily and cheaply to design and fabricate, it is the simplest way to realise a base band filter.

Alternatively, it is an advantage to use active filters as the base band filters. Active filters show excellent filter characteristics. By using active filters inductors are avoided, because using active filters inductors can be replaced by a circuit consisting of, for example, capacitors, resistors and operational amplifiers.

Combining an active filter with an amplifier in a feedback loop has the advantage to control the filter characteristics by changing the gain in the amplifier, which is used as the feedback network. Using active filters enables the fabrication of the base band filters with standard integrated circuit technology, because every component can then be realised by using integrated circuits.

Moreover, it is an advantage that the receiver automatically selects the frequency bandwidth and frequency band for the actual mode that is used for transmission.

It is possible for the user to select the signal, e. g. GSM or UMTS. Since the user should know which mode he wants to use, he can simply switch to this mode by using the interface of his mobile phone. Alternatively, necessary filter characteristics for the reception mode are automatically set.

Drawings

Exemplary embodiments of the invention are shown in the figures, and elucidated in detail in the description below. Figure 1 shows a direct conversion receiver for receiving GSM and UMTS-Signals, figure 2 shows a controllable low pass filter with passive components, figure 3 shows a controllable LC-filter, figure 4 shows a controllable active filter, and figure 5 shows active filters connected together in a feedback loop.

Description

Today in many countries, competing standards for mobile communications are co-existing. Therefore, users of mobile communications need a device capable of supporting more than one mode because of a necessary flexibility. In a few years, the GSM standard and the new upcoming UMTS standard will coexist

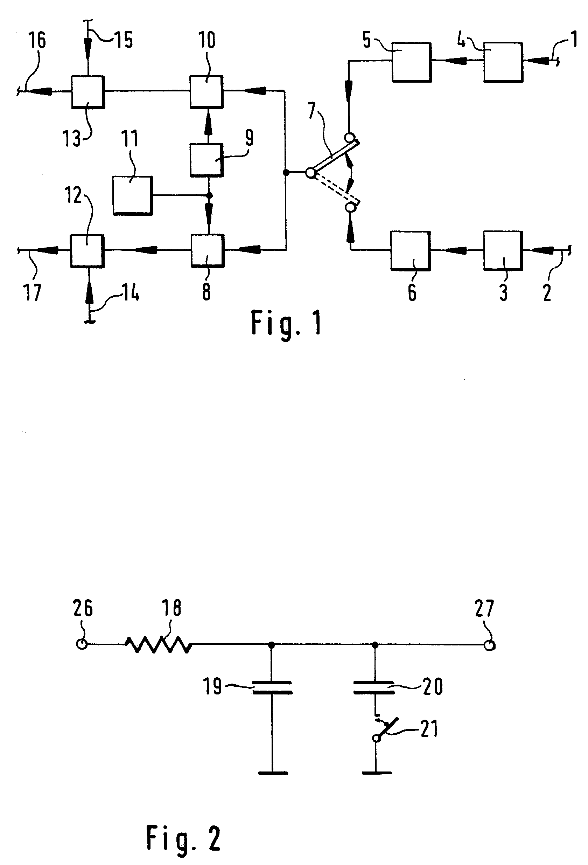

In Fig. 1, a direct conversion receiver for receiving GSM and UMTS signals is shown. Direct conversion means that the signals are directly downconverted from the frequency of the received radio frequency signal to the base band.

The UMTS signal is applied to an input 1. The UMTS-signal is then filtered by a band pass filter 4 designed for the frequency band of the UMTS-signal and subsequently amplified by an amplifier 5.

GSM signals are entering via an input 2. GSM-signals are then filtered by a band pass filter 3, and subsequently amplified by an amplifier 6. By using the switch 7 either the UMTS signal or the GSM signal is selected for further processing in the following components. The switch 7 is a set of transistors which are configured in a conventional way, known for using transistors as a switch. Other possibilities are to use a set of diodes or combined high pass and low pass filters.

GSM is a widely used standard for digital wireless, cellular communications, especially for mobile phones. UMTS is the following standard which will come into use in a few years. The UMTS standard improves and expands the functionality of today's standard like GSM. Higher data transmission rate, better voice quality, better spectrum efficiency and multimedia service capability are examples for those improvements.

The signal travelling over the switch 7, goes simultaneously in directions of two signal paths to subsequent components. Two signal paths are needed to implement the well-known quadrature technique to demodulate the received signal and output the base band in-phase and quadrature signals. In one path the received signal is multiplied with the signal coming directly from the local oscillator 11 whereas in the other path the received signal is multiplied with a 90° phase shifted signal from the local oscillator 11.

The mixers 8 and 10 are both used to downconvert the signal to the base band. A mixer is used to multiply two signals. In integrated circuits the mixer is usually realised as a transistor mixer. The base band is the frequency band where the signals originally occur. The low frequency baseband bandwidth for GSM is approximately 100 kHz and for UMTS 2.5 MHz.

The received signal is mixed with a signal, coming from the local oscillator 11. The signal for the mixer 10 is phase shifted by a phase shifter 9 by 90°. The phase shifter 9 is placed between the local oscillator 11 and the mixer 10. A phase shifter is, for example, a frequency doubler combined with two flip-flops. The frequency doubler, e. g. a transistor coupling, doubles the frequency of the incoming signal, whereas the flip-flops halves the frequency again by reacting only on changes of the signal amplitude from zero to maximum or vice versa. Additionally, one flip-flop exhibits an inverted input to form the 90° shifted signal, whereas the other flip-flop produces the non-shifted signal. Thus, at the outputs of the flip-flops, the original signal and the 90° shifted signal are available.

The downconverted received signal in the two paths is then filtered by controllable low pass filters 12 and 13. A low pass filter is a filter strongly attenuating the signal components at frequencies higher than the cut-off frequency of the low pass filter.

The cut-off frequency is the frequency marking the point, where the response of the filter drops off by 3 dB. This means, that the output voltage is lowered by $\sqrt{2}/2$ compared to the output voltage at the wanted frequencies.

Ideally, only signal components at frequencies lower than the cut-off frequency are available at the output of the low pass filter.

The low pass filter 12 filters the signal coming from the mixer 8. The low pass filter 13, however, filters the signals coming from the mixer 10. The low pass filter 12 is controlled by an input 14. The low pass filter 13 is controlled by an input 15. By using the inputs 14 and 15 the cut-off frequency of the low pass filters 12 and 13 can be altered. The inputs 14 and 15 are automatically set by the mobile phone when the user chooses either GSM signals or UMTS signals for reception. For GSM a cut-off frequency of 100 kHz is used and for UMTS a cut-off frequency of 2.5 MHz is used.

At an output 16 of the low pass filter 13 and an output 17 of the low pass filter 12, the two parts of the received signals are available for further processing. By processing and combining the signals at the outputs 16 and 17, it is possible to re-construct the downconverted signal in the base band.

In Fig. 2, a controllable low pass filter consisting of passive components is shown.

An input 26 for the received signal is connected to a resistor 18. The resistor 18 is on the other side then connected to two capacitors 19 and 20 and an output 27 of the base band filter. The capacitor 20 is on the other side connected via a switch 21 to mass. The capacitor 19 is on the other side directly connected to mass.

This architecture consisting of a resistor and a capacitor is known as a classical low pass filter, both elements being connected in series. The output voltage is taken over the capacitor, whereas the input voltage is applied to the resistor and the capacitor. In principle, it is a voltage divider.

The switch 21 is a transistor switch but other implementations are possible as mentioned above. If this switch is in on state, it will lead to the addition of the capacitance of the capacitor 20 to the capacitance of the capacitor 19, since if capacitors are connected in parallel, the capacitance of each capacitor is added, so that the sum of all capacitances of each capacitors is the resulting capacitance. Therefore by switching on switch 21, the capacitance is increased by the capacitance of the capacitor 20. In this way, the cut-off frequency is decreased, since the equation for the cut-off frequency of a base band filter consisting of a resistor and a capacitor is

$$f_{cut\text{-}off} = \frac{1}{2 \cdot \pi \cdot R \cdot C},$$

where R is the resistance of the resistor and C is the capacitance of the capacitor or the sum of the capacitances of all capacitors in the low pass filter being in parallel.

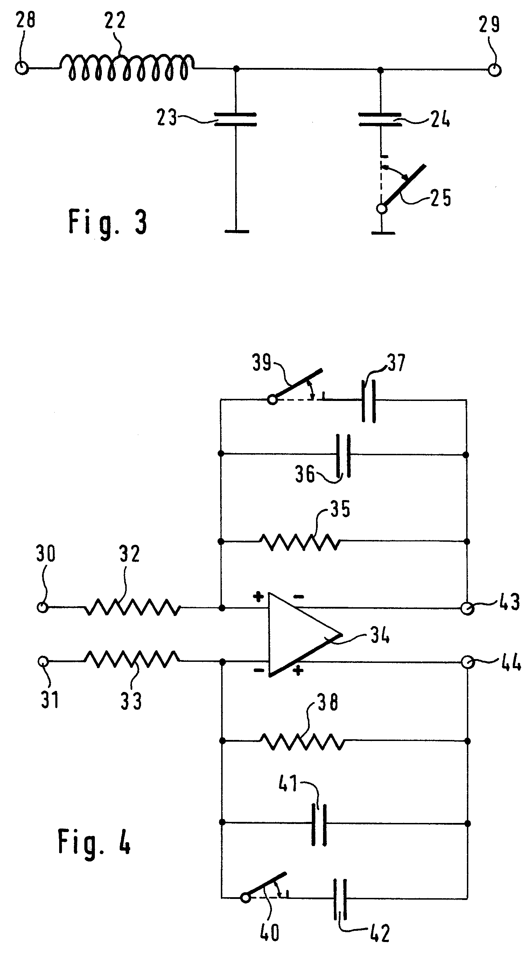

In Fig. 3, a typical LC-filter is shown. An LC-filter consists of an inductor and a capacitor connected in series, the output voltage being taken over the capacitor. This LC-filter exhibits the property of increasingly attenuating signal components at frequencies having an increasing difference with the resonance frequency

$$f_{res} = \frac{1}{2 \cdot \pi \cdot \sqrt{L \cdot C}},$$

where L is the inductance of the inductor and C the capacitance of the capacitor.

An incoming signal enters the LC-filter via the input 28. The input 28 is connected an inductor 22. The inductor 22 is connected to a capacitor 23, another capacitor 24 and an output 29. The capacitor 23 is directly connected to mass. The capacitor 24 is connected to a switch 25 which is connected to mass.

By switching on the switch 25 to capacitance of the capacitor 24 is added to the capacitance of the capacitor 23. That means, the cut-off frequency of the filter is thereby lowered. This circuit has the advantage of a very steep filter curve.

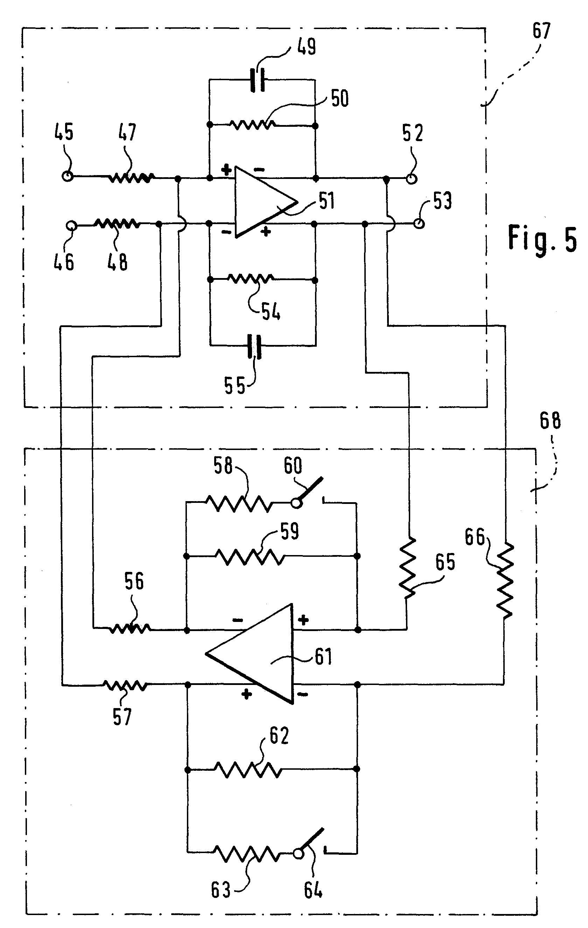

In Fig. 4, an active filter setup is shown for the low pass filter.

An active filter exhibits an active element such as a transistor or an operational amplifier apart from passive elements. In addition, an active filter can show a gain in its passband, so it amplifies the signal. An active filter design has the advantage that inductors can be avoided, but nevertheless a very steep fall off outside the used frequency band is achieved by cascaded filter, which is not possible by a conventional low pass filter consisting of a resistor and a capacitor. In addition, this circuit in Fig. 4 can be easily realised by a integrated circuit design. The switches 39 and 40 are again conventional transistor switches.

An input 30 for a signal is connected to a resistor 32. An input 31 is connected to a resistor 33. The resistor 32 is on the other side connected to the positive input of an operational amplifier 34, to a resistor 35, the capacitor 36 and to a switch 39. The resistor 33 is on the other side connected to a negative input of the operational amplifier 34, to a resistor 38, to the capacitor 41 and to the switch 40.

The switch 39 is on its other side connected to a capacitor 37. The capacitor 37 is on its other side connected to the capacitor 36, to resistor 35, to the negative output of the operational amplifier and the output 43 of the active filter.

The switch 40 is on its other side connected to the capacitor 42. The capacitor 42 is on its other side connected to the capacitor 41, to the resistor 38, the positive output of the operational amplifier 34 and the output of the filter 44.

An incoming signal, entering the active filter over the inputs 30 and 31, experiences the voltage divider of the resistor 32 and the parallel circuit of the resistor 35, the capacitor 36 and the capacitor 37, if the switch 39 is on. This voltage divider, which is mirrored for the other input with the same corresponding elements acts as a low pass filter. By switching on the switches of 39 and 40, the capacitance is again increased, so that the cut-off frequency of this low pass filter is decreased. Then, the low cut-off frequency for GSM is set, whereas, if the switches 39 and 40 are switched off, the high cut-off frequency for UMTS is set.

In Fig. 5, a feedback design using active filters for realising a low pass filter is shown. An incoming signal enters this filter via an input 45 and an input 46. The signal experiences an active filter 67 being a low pass filter having an amplifier design 68 as a feedback.

The input 45 is connected to a resistor 47 and the input 46 is connected to a resistor 48. The resistor 47 is on its other side connected to a positive input of an operational amplifier 51, to a resistor 50, to a capacitor 49 and to a resistor 56. The resistor 48 is on its other side connected to a negative input of the operational amplifier 51, to a resistor 54, to a capacitor 55 and to a resistor 57.

The capacitor 49 is on its other side connected to the resistor 50, to an output 52, to a negative output of the operational amplifier 51 and to a resistor 66. The capacitor 55 is on its other side connected to the resistor 54, to a positive output of the operational amplifier 51, to a resistor 65 and to an output 53.

The resistor 56 is on its other side connected to a resistor 58, to a resistor 59 and to negative output an operational amplifier 61. The resistor 57 is on its other side connected to a positive output of the operational amplifier 61, to a resistor 62 and to a resistor 63.

The resistor 66 is on its other side connected to a negative input of the operational amplifier 61, to the resistor 62 and to a switch 64. The switch 64 is connected to the resistor 63.

The resistor 65 is on its other side connected to a positive input of the operational amplifier 61, to the resistor 59 and to a switch 60. The switch 60 is on its other side connected to the resistor 58.

The active filter 67 is a low pass filter whereas the circuit 68 around the operational amplifier 61 is an amplifier, the gain depending on whether the switches 60 and 64 are in on or off state, since the gain of an operational amplifier design depends on the ratios of resistances in the feedback loop of the operational amplifier and the resistors 65 and 66.

Furthermore, the state of the switches determines the cut-off frequency of the low pass design 67, since it changes the resistance affecting the cut-off frequency.

The switches are again transistor switches, so that the whole design presented in Fig. 5 is realised by integrated circuit technology.

The values of the resistors and capacitors are designed, so that the cut-off frequencies for UMTS, approximately 2.5 MHz, and for GSM, approximately 100 kHz, can be realised.

Apart from designing operational amplifiers with symmetrical circuit elements in two feedback loops, that means that there are circuit elements between the inputs and outputs of an operational amplifier which do not belong to the operational amplifier itself, operational amplifiers can be designed with the circuit elements in only one feedback loop, for example, between the negative input of the operational amplifier and the output of the operational amplifier whereas the positive input of the operational amplifier is connected to mass. This gives then an inverted output voltage.

The advantage to have the circuit elements mirrored in two feedback loops, so that neither input or output is connected to mass leads to an independence from mass and to an easier circuit design because in integrated circuit technology it is easy to fabricate identical circuit elements.

Another alternative to realise the low pass filter, is to use digital filters. Digital filters are realised on digital processors, e. g. a digital signal processor which is designed to provide high speed processing, especially by performing a multiplication and accumulation in one step. Besides this, the digital processor can be easily reprogrammed.

Thus, the low pass filter 12 and 13 in Fig. 1 are implemented in the digital signal processors on which the software programs being the digital filters are running.

The digital filter being a software program running on a digital signal processor consists of elements that delay the incoming signals, of elements for multiplying the signals with predefined factors and of elements for adding the differently multiplied and delayed signals in the digital filter. By combining these elements, the desired filter characteristic is achieved. Thus, a digital filter works in the time domain. These elements are realised in the software program by performing the necessary functions: storing the signal for a time corresponding to a delay unit, multiplying the signal with a predefined factor and adding differently delayed parts of the signal.

Widely known software packages enable the design of digital filters by specifying the desired filter characteristic. By programming the digital signal processors it is possible to alter the filter characteristics of the digital filter. In this way it is very easy to adapt to further characteristics to an incoming signal.

The receiver after the invention exhibits the ability to automatically select the frequency bandwidth and cut-off frequency for actual transmission mode, GSM or UMTS. The receiver detects what mode a transmitter is using by processing received signals. A signalling is used, so that the communicating radio stations know what mode is used, so that the radio station can adjust their filters.

## Claims

1. Receiver for receiving signals with different frequency bandwidths in different frequency bands, the said receiver exhibiting a local oscillator (11) and using the said local oscillator (11) to downconvert the said signals in said different frequency bands to the base band characterised in that the receiver comprises controllable base band filters (12, 13) in order to select said signals with said different frequency bandwidths in the base band.

2. Receiver after claim 1 wherein the said base band filters (12, 13) are digital filters.

3. Receiver after claim 1 wherein the said base band filters (12, 13) are filters consisting of passive elements.

4. Receiver after claim 1 wherein the said base band filters (12, 13) are active filters.

5. Receiver after claim 4 wherein the said base band filters (12, 13) are active filters with a feedback circuit.

6. Receiver after claim 5 wherein the feedback circuit is an amplifier design.

7. Receiver after claim 2, 3 or 5 wherein the receiver automatically selects the frequency bandwidth and cut-off frequency.

8. Receiver after claim 2, 3 or 5 wherein the user selects the signal, GSM or UMTS, for reception.

9. Receiver after claim 8 wherein the cut-off frequency of the base band filters (12, 13) is set by the receiver depending on the selected signal by the user.

Fig. 1

Fig. 2

28  22

23  24

25

Fig. 3

39  37

36

35

30  32

31  33

+  −

34  43

−  +  44

38

41

Fig. 4

40  42

Fig. 5

**European Patent Office**

# EUROPEAN SEARCH REPORT

Application Number

EP 99 12 1803

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | WO 99 25075 A (KONINKL PHILIPS ELECTRONICS NV ;PHILIPS AB (SE)) 20 May 1999 (1999-05-20) | 1-3,7-9 | H04B1/40 H04B1/30 H03H11/12 |
| A | * abstract * <br> * page 1, line 1 - page 9, line 16 * <br> * figure 1 * <br> * figure 4 * <br> * figure 5 * <br> ---- | 4 | |
| X | US 5 604 927 A (MOORE PAUL A) 18 February 1997 (1997-02-18) | 1,4,7-9 | |
| A | * abstract * <br> * column 1, line 1 - column 2, line 61 * <br> * column 3, line 26 - column 4, line 25 * <br> * figure 2 * <br> * figure 3 * <br> --- | 2,3,5 | |
| X | WO 99 34625 A (ERICSSON TELEFON AB L M) 8 July 1999 (1999-07-08) | 1,2,7-9 | |
| A | * abstract * <br> * page 5, line 10 - page 7, line 23 * <br> * page 8, line 26 - page 20, line 23 * <br> * figure 2 * <br> --- | 3,4 | TECHNICAL FIELDS SEARCHED (Int.Cl.7) |
| A | EP 0 142 586 A (BUDAPESTI RADIOTECHNIKAI GYAR) 29 May 1985 (1985-05-29) * abstract * <br> * page 11, line 1 - page 13, line 20 * <br> * figure 1 * <br> ----- | 4-6 | H04B H03H |

The present search report has been drawn up for all claims

| Place of search | Date of completion of the search | Examiner |
|---|---|---|
| THE HAGUE | 23 March 2000 | Lindhardt, U |

EPO FORM 1503 03.82 (P04C01)

# EP 1 098 449 A1

## ANNEX TO THE EUROPEAN SEARCH REPORT
## ON EUROPEAN PATENT APPLICATION NO.

EP 99 12 1803

This annex lists the patent family members relating to the patent documents cited in the above-mentioned European search report.
The members are as contained in the European Patent Office EDP file on
The European Patent Office is in no way liable for these particulars which are merely given for the purpose of information.

23-03-2000

| Patent document cited in search report | | Publication date | Patent family member(s) | | Publication date |
|---|---|---|---|---|---|
| WO 9925075 | A | 20-05-1999 | EP | 0958660 A | 24-11-1999 |
| US 5604927 | A | 18-02-1997 | EP | 0686324 A | 13-12-1995 |
| | | | WO | 9519073 A | 13-07-1995 |
| | | | JP | 8507430 T | 06-08-1996 |
| WO 9934625 | A | 08-07-1999 | AU | 2082099 A | 19-07-1999 |
| | | | SE | 9704896 A | 30-06-1999 |
| EP 0142586 | A | 29-05-1985 | NONE | | |

EPO FORM P0459

For more details about this annex : see Official Journal of the European Patent Office, No. 12/82

10